# EUROPÄISCHE PATENTANMELDUNG

(11) **EP 1 336 985 A1**
(43) Veröffentlichungstag der Anmeldung: **20.08.2003**
(21) Anmeldenummer: 02003752.9
(22) Anmeldetag: 19.02.2002
(51) Int. Cl.: H01J 37/34, C23C 14/35

(54) **Zerstäubungskathode und Vorrichtung und Verfahren zum Beschichten eines Substrates mit mehreren Schichten**

(71) Anmelder: Singulus Technologies AG, 63796 Kahl/Main (DE)
(72) Erfinder: Maass, Wolfram, Dr., 63589 Linsengericht-Grossenhausen (DE); Schneider, Roland, 63679 Schotten - Michelbach (DE); Mühlfeld, Uwe, 63939 Wörth (DE); Mundorf, Christoph, 63796 Kahl (DE); Ocker, Berthold, 63454 Hanau (DE); Langer, Jürgen, Dr., 63071 Offenbach (DE); Schneider, Dietmar, 61137 Schöneck (DE); John, Helmut, 63452 Hanau (DE); Spielvogel, Rudi, 63607 Wächtersbach (DE); Claussen, Eric, 63457 Hanau (DE); Stern, Wolfgang, 63456 Hanua (DE); Lausmann, Helmut, 63584 Gründau (DE); Landmann, Matthias, 61130 Nidderau (DE); Sommerfeld, Reinhard, 63486 Bruchköbel-Rossdorf (DE)
(74) Vertreter: VOSSIUS & PARTNER

(57) **Zusammenfassung**

Die Erfindung betrifft eine Zerstäubungskathode (1) für die Beschichtung eines Substrates (6) mit einer Einrichtung (5) zum Erzeugen eines externen Magnetfeldes mit im wesentlichen parallel verlaufenden Magnetfeldlinien (8) im wesentlichen in der Ebene des Substrates. Ferner betrifft die Erfindung eine Vorrichtung und ein Verfahren zum Beschichten eines Substrates mit mehreren Schichten, wobei mehrere Zerstäubungskathoden mit ihrer Targetnutzfläche radial nach außen weisend auf einem Kreis angeordnet sind.

## Beschreibung

Die Erfindung betrifft eine Zerstäubungskathode für die Beschichtung eines Substrates, insbesondere mit magnetischen Werkstoffen. Ferner betrifft die Erfindung eine Vorrichtung und ein Verfahren zum Beschichten eines Substrates durch Kathodenzerstäubung, insbesondere mit magnetischen Werkstoffen.

Aus der DE-A-196 43 841 ist eine Vorrichtung zum Beschichten von Substraten, insbesondere mit magnetisierbaren Werkstoffen bekannt. Diese Vorrichtung besteht aus einem kreisscheibenförmigen, rotierbar gelagerten Substrathalter zur Aufnahme mindestens eines Substrates, der auf seiner dem Substrat abgewandten Seite und längs des Umfanges mit einer konzentrischen Dunkelraumabschirmung versehen ist, aus einer Einrichtung zur Erzeugung eines zur Substratebene parallelen äußeren Feldes sowie mindestens einer Kathode, unter der sich der Substrathalter während der Beschichtung dreht. Das äußere Feld dieser Vorrichtung wird durch einen Elektromagneten mit Joch erzeugt, wobei das untere Jochteil mit der Erregerspule in der Dunkelraumabschirmung und seine verlängerten Polschuhe elektrisch getrennt im Substratträger in der Nähe des Substrates untergebracht sind. Eingelassen in den Substrathalter wird das Substrat im dynamischen Betrieb dieser Vorrichtung unter der Kathode durchgedreht und mit dem Targetmaterial beschichtet.

Aus der DE-A-41 35 939 ist eine rotationssymmetrische Zerstäubungskathode bekannt, die auch in Form einer Langkathode ausgebildet sein kann. Bei Ausbildung dieser Zerstäubungskathode als Langkathode wird das Substrat dann bei seiner Relatiwerschiebung gegenüber der Kathode beschichtet.

In der Speichertechnologie findet zunehmend der sogenannte MRAM (Magnetic Random Access Memory) als nicht flüchtiger Speicher Verwendung. Bei diesen Speichern wird die zu speichernde Information in der Magnetisierungsrichtung eines Partikels einer magnetischen Beschichtung gespeichert. Das Auslesen der Information kann mittels zweier alternativer Verfahren erfolgen, des sogenannten TMR-Effektes (Tunnel Magneto Resistance) oder des sogenannten GMR-Effektes (Giant Magneto Resistance).

Für diese Art der Speicher ist es erforderlich, extrem dünne Schichten (in der Größenordnung von wenigen Å), die extrem gleichmäßig auf einem Substrat aufgetragen werden, bereitzustellen. Die Speicherfähigkeit dieser extrem dünnen Schicht wird durch eine Magnetisierung der Schicht auf dem Substrat erreicht. Dabei wird die leichte Magnetisierungsachse des magnetischen Materials, beispielsweise eines ferromagnetischen Materials, über die gesamte Fläche des Substrates in eine Richtung ausgerichtet. Bei dieser Ausrichtung der leichten Magnetisierungsachse sind höchstens Abweichungen in der Größenordnung von +/- 2° zulässig.

Ferner ist es für solche magnetische Speicher notwendig, bis zu zehn oder mehr Schichten übereinander aufzubringen.

Mit bisher bekannten Zerstäubungskathoden ist es nicht möglich, solch extrem dünne Schichten mit der erforderlichen Genauigkeit bezüglich der Ausrichtung der leichten Magnetisierungsrichtung herzustellen. Die Verwendung von rotationssymmetrischen Zerstäubungskathoden ist beispielsweise mit dem Nachteil verbunden, daß das in der Zerstäubungskathode für die Zerstäubung notwendige rotationssymmetrische Magnetfeld eine Ausrichtung der leichten Magnetisierungsachse in den Substratschichten in eine Richtung stört.

Ein weiterer Nachteil von rotationssymmetrischen Magnetron-Zerstäubungskathoden liegt darin, daß mit diesen bei den erforderlichen Schichtdicken von wenigen Å die erforderliche extreme Homogenität und Gleichmäßigkeit nicht zu erreichen ist.

Ein weiteres Problem in der Erzeugung von magnetisierbaren Schichten, insbesondere für MRAM-Speicher, auf einem Substrat liegt in dem extrem hohen Vakuum, das erforderlich ist, um die extrem dünnen Schichten mit der extremen Gleichmäßigkeit auf das Substrat aufbringen zu können.

Der Erfindung liegt die Aufgabe zugrunde, eine Zerstäubungskathode anzugeben, mit der eine Ausrichtung der leichten Magnetisierungsachse eines magnetisierbaren Werkstoffes während des Aufbringens des Werkstoffes auf ein Substrat möglich ist.

Ferner ist eine Vorrichtung und ein Verfahren zum Beschichten eines Substrates mit mehreren Schichten durch Kathodenzerstäubung anzugeben, mit der die für magnetische Speicher erforderlichen dünnen Schichten mit der geforderten hohen Gleichmäßigkeit bereitgestellt werden können.

Diese Aufgabe wird erfindungsgemäß mit den Merkmalen der Patentansprüche gelöst.

Zum Aufbringen von magnetischen Werkstoffen auf Substrate mit der notwendigen Ausrichtung der leichten Magnetisierungsachse des Werkstoffes geht die Erfindung von dem Grundgedanken aus, eine Zerstäubungskathode mit einer Einrichtung zum Erzeugen eines externen Magnetfeldes zu versehen, wobei das Magnetfeld im wesentlichen parallel verlaufende Magnetfeldlinien aufweist, die im wesentlichen in der Ebene des zu beschichtenden Substrates liegen. Vorzugsweise ist die Stärke des externen Magnetfeldes abhängig von dem verwendeten magnetischen Werkstoff einstellbar, so daß geeignet bei der Ausrichtung der leichten Magnetisierungsachse in der magnetische Schicht auf den verwendeten Werkstoff Rücksicht genommen werden kann.

Weiter bevorzugt ist die erfindungsgemäße Zerstäubungskathode eine Langkathode. Die Verwendung einer Langkathode ist mit dem Vorteil verbunden, daß die von deren Magnetanordnung hervorgerufenen Streufelder nicht rotationssymmetrisch verlaufen, sondern sich mit den im wesentlichen parallel verlaufenden Magnetfeldlinien des externen Magnetfeldes decken, so daß diese Streufelder bei der Ausrichtung der magnetischen Partikel nur noch eine untergeordnete Rolle spielen. Ferner ist die Verwendung einer Langkathode mit dem Vorteil verbunden, daß das zu beschichtende Substrat auf einfache Art und Weise unter dem Target hindurch bewegt werden kann. Dieser Unterschied zum Stand der Technik (wo das Magnetfeld mit dem Substrat mitbewegt wird), d.h. das ortsfeste externe Magnetfeld, ist mit dem besonderen Vorteil verbunden, daß bei einer Relativbewegung des Substrates unter dem Target hindurch und durch das externe Magnetfeld zum einen eine einfache und exakte Ausrichtung der leichten Magnetisierungsachse ermöglicht wird, und andererseits unabhängig von der Leistung der Zerstäubungskathode auf einfache Art und Weise die gewünschte geringe Schichtdicke des aufzubringenden Werkstoffes eingestellt werden kann. Die Geschwindigkeit des Substrates bestimmt bei dieser Art der Beschichtung die Schichtdicke der aufzubringenden Schicht.

In der bevorzugten Ausführungsform, daß die Zerstäubungskathode eine Langkathode ist, erstreckt sich die externe Magnetfelderzeugungseinrichtung entlang der Ausbreitungsrichtung des Targets der Langkathode. Dies bedeutet, daß entlang der gesamten Ausbreitungsrichtung des Targets ein externes Magnetfeld zur Ausrichtung der leichten Magnetisierungsachse eines auf ein relativ zum Target bewegten Substrates aufgebrachten Werkstoffes ausgerichtet werden kann.

Da das Substrat notwendigerweise während der Beschichtung unter Einhaltung eines gewissen Anstandes zum Target angeordnet ist, ist vorzugsweise ferner eine Abschirmung zum Abschirmen des nicht zu beschichtenden Bereiches der Kathode zwischen Target und Substrat vorgesehen.

Vorzugsweise ist ferner eine Einrichtung zur Relativbewegung des Substrates bezüglich der Kathode während der Kathodenzerstäubung vorgesehen. Mehr bevorzugt ist dabei, daß diese Bewegungseinrichtung eine translatorische Relativbewegung des Substrates bezüglich der Kathode bereitstellt.

Weiter bevorzugt ist bei der erfindungsgemäßen Zerstäubungskathode der Kathodengrundkörper mit dem darauf angeordneten Target in einem Prozeßraum angeordnet, während die dem Kathodengrundkörper und dem Target zugeordnete Magnetanordnung nicht in dem Prozeßraum vorgesehen ist, sondern von diesem durch eine Wand getrennt in der Umgebungsatmosphäre angeordnet ist. Diese Anordnung ist besonders vorteilhaft, um das beim Beschichten von Substraten für die Bereitstellung von magnetischen Speichern notwendige Ultrahochvakuum bereitzustellen. Durch diese bevorzugte Ausgestaltung bzw. Trennung zwischen Target und Magnetanordnung ist es möglich, die Öffnungen zum Prozeßraum wesentlich kleiner zu gestalten, da nur noch die Kühlflüssigkeits- und Stromzuführung für die Kathode in den Prozeßraum erfolgen muß. Diese kann jedoch kombiniert werden und nur diese Zuführung muß bei der bevorzugten Ausgestaltung noch abgedichtet werden. Somit sind wesentlich kleinere Dichtlängen möglich (diese betrugen bisher pro Target etwa einen Meter).

Die erfindungsgemäße Vorrichtung zum Beschichten eines Substrates mit mehreren Schichten durch Kathodenzerstäubung, insbesondere mit magnetischen Werkstoffen, zeichnet sich dadurch aus, daß eine Anordnung mehrerer Zerstäubungskathoden mit je einem Kathodengrundkörper, einem darauf angeordneten Target und einer hinter dem Target angeordnete Magnetanordnung vorgesehen ist, wobei die mehreren Zerstäubungskathoden mit ihrer Targetnutzfläche radial nach außen weisend auf einem Kreis angeordnet sind, um dessen Mittelpunkt die Zerstäubungskathodenanordnung relativ zu dem Substrat drehbar ist. Das Substrat ist im wesentlichen in einer Tangentialebene eines die Zerstäubungskathodenanordnung umschreibenden Kreises angeordnet.

Durch diese erfindungsgemäße Anordnung der mehreren Zerstäubungskathoden, die für die Aufbringung mehrerer unterschiedlicher Schichten auf das Substrat erforderlich sind, in Form eines Kreises bzw. in Form einer Trommel ist es möglich, bei der Beschichtung der mehreren Schichten eine sehr hohe Gleichmäßigkeit und Homogenität zu erreichen, da das Substrat während der unterschiedlichen Beschichtungsvorgänge in seiner Ebene gehalten werden kann, während die verschiedenen Targets in die jeweilige Zerstäubungsposition gedreht werden können. Die Anordnung der Zerstäubungskathoden in Form einer Targettrommel ist ferner mit dem Vorteil verbunden, daß die gesamt Beschichtungsvorrichtung sehr kompakt ist. Eine solche Targettrommel kann beispielsweise liegend, d.h. mit horizontaler Längsachse ohne weiteres an herkömmliche Substrat-Beschickungsmodule angebaut werden.

Vorzugsweise sind die Zerstäubungskathoden Langkathoden. Für die damit verbunden Vorteile gilt das oben genannte entsprechend.

Weiter bevorzugt ist die erfindungsgemäße Beschichtungsvorrichtung mit einer externen Magnetfelderzeugungseinrichtung versehen, deren Magnetfeldlinien im wesentlichen parallel und in der Ebene des Substrates verlaufen. Hierdurch werden die magnetischen Partikel bezüglich ihrer leichten Magnetisierungsachse ausgerichtet, und für die damit verbundenen Vorteile gilt das oben gesagte entsprechend.

Die externe Magnetfelderzeugungseinrichtung ist bezüglich der Zerstäubungskathodenanordnung ortsfest, d.h. die Zerstäubungskathodenanordnung ist relativ zur Magnetfelderzeugungseinrichtung drehbar. Je nach zu verwendendem Target wird dieses in der Beschichtungsvorrichtung durch Drehen der Zerstäubungskathodenanordnung in die Zerstäubungsposition relativ zum Substrat gedreht und befindet sich somit auch im Einflußbereich des externen Magnetfeldes, das auf die Schicht einwirkt, die vom gerade verwendeten Target auf das Substrat aufgebracht wird.

Vorzugsweise ist bei der erfindungsgemäßen Beschichtungsvorrichtung nicht für jede Zerstäubungskathode bzw. nicht für jedes Target eine gesonderte Magnetanordnung vorgesehen, sondern lediglich eine oder zwei Magnetanordnungen, die wahlweise über dem zu verwendenden Target in Position gebracht werden können. Dies ermöglicht eine weitere Kompaktierung der erfindungsgemäßen Beschichtungsvorrichtung, d.h. die Targettrommel kann einen kleineren Durchmesser aufweisen, da im Inneren nur noch Raum für eine oder gegebenenfalls zwei Magnetanordnungen vorhanden sein muß. So kann beispielsweise für magnetische und nicht-magnetische Materialien eine unterschiedliche Magnetanordnung bereitgestellt sein bzw. verwendet werden.

Das erfindungsgemäße Verfahren zum Beschichten eines Substrates durch Kathodenzerstäubung, insbesondere mit einer erfindungsgemäßen Zerstäubungskathode, zeichnet sich dadurch aus, daß während der Zerstäubung ein externes Magnetfeld mit im wesentlichen parallel und in der Ebene des Substrates verlaufenden Magnetfeldlinien vorgesehen ist.

Das Verfahren zum Beschichten eines Substrates mit mehreren Schichten, insbesondere mit magnetischen Werkstoffen, ist von dem Grundgedanken gekennzeichnet, ein Substrat mittels einer translatorischen Bewegung relativ zu einer Zerstäubungskathode im wesentlichen in der Ebene des Substrates zu bewegen und dabei eine Schicht auf das Substrat aufzubringen. Diese Bewegung des Substrates relativ zur Kathode kann vorzugsweise mehrmals wiederholt werden, wenn dies zur Erreichung einer erforderlichen Schichtdicke erforderlich ist. Anschließend wird die Zerstäubungskathode durch eine weitere Zerstäubungskathode ersetzt und die bisherigen Schritte werden wiederholt.

Die Erfindung ist besonders geeignet für Viellagenschichten mit vielen verschiedenen Materialien auch außerhalb des Anwendungsbereiches der MRAM-Technologie.

Die Erfindung wird nachstehend unter Bezugnahme auf die beigefügten Zeichnung näher erläutert. Es zeigen:
- Figur 1: eine schematische Schnittdarstellung der erfindungsgemäßen Zerstäubungskathode;
- Figur 2: eine schematische Darstellung der Ausrichtung der leichten Magnetisierungsachse eines ferromagnetischen Materials auf einem Substrat;
- Figur 3: eine Schnittansicht der erfindungsgemäßen Substrat-Beschichtungsvorrichtung mit Langkathoden;
- Figur 4: eine Schnittansicht der erfindungsgemäß bevorzugten Trennung von Magnetanordnung und Target;
- Figur 5: eine schematische Übersicht einer kompletten Beschichtungsanlage mit zwei erfindungsgemäßen Beschichtungsvorrichtungen; und
- Figur 6: eine schematische Darstellung der Bewegungseinrichtung für die translatorische Bewegung des Substrates.

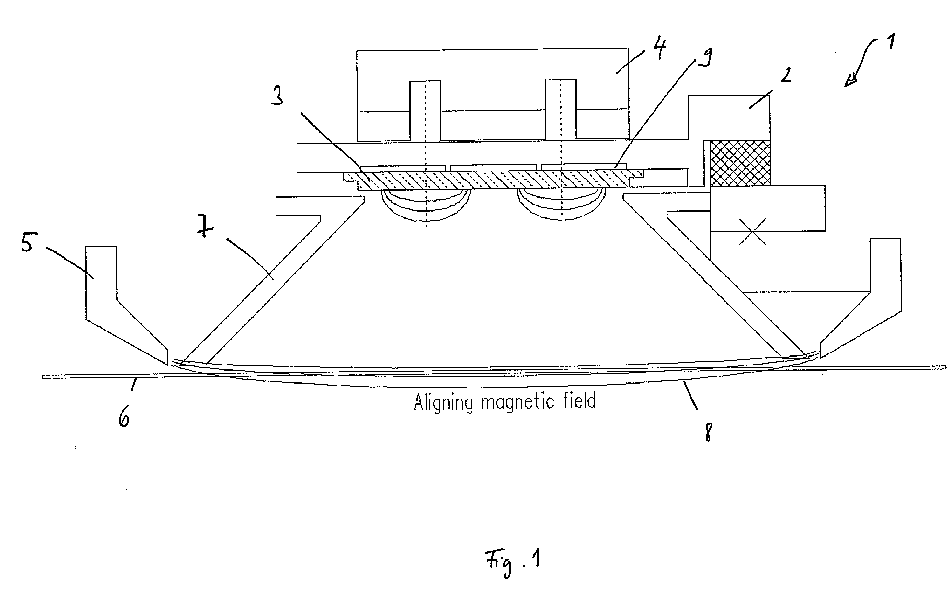

Figur 1 zeigt anhand einer Langkathode den prinzipiellen Aufbau der erfindungsgemäßen Zerstäubungskathode 1. Die erfindungsgemäße Zerstäubungskathode dieser bevorzugten Ausführungsform weist einen Kathodengrundkörper 2 mit einem darauf angeordneten Target 3 auf. Zwischen Target 3 und Kathodengrundkörper 2 sind Kühlkanäle 9 vorgesehen. Auf der dem Target abgewandten Seite des Kathodengrundkörpers ist eine Magnetanordnung 4 vorgesehen, deren magnetisches Feld unterhalb des Targets angedeutet ist. Das Substrat 6 ist beabstandet von dem Target 3 angeordnet. In der gezeigten Ausführungsform befindet sich das Substrat 6 in einer Ebene, die im wesentlichen parallel zum Target 3 ist. Alternativ dazu kann die Ebene des Substrates auch leicht zur Ebene des Targets 3 geneigt sein.

Ferner ist eine Einrichtung 5 zum Erzeugen eines externen Magnetfeldes vorgesehen. In Figur 1 sind lediglich die beiden Polschuhe angedeutet, die jedoch mit einer entsprechenden Spulenanordnung in elektromagnetischer Verbindung stehen. Diese Magnetfelderzeugungseinrichtung 5 erzeugt ein externes Magnetfeld, dessen Feldlinien mit den Bezugszeichen 8 in Figur 1 angedeutet sind. Die Magnetfeldlinien dieses externen Magnetfeldes verlaufen im wesentlichen in der Ebene des Substrates 6 und darin im wesentlichen parallel zueinander, um so die gewünschte parallele Ausrichtung der leichten Magnetisierungsachse zu erreichen.

Zwischen dem Target und dem Substrat ist ferner eine Abschirmung 7 vorgesehen, die nicht zu beschichtende Bestandteile der Zerstäubungskathode abschirmt und lediglich eine Restfläche bildet.

Die gewünschte Ausrichtung der leichten Magnetisierungsachse wird mit der erfindungsgemäßen Zerstäubungskathode 1 erreicht, sowohl wenn das Substrat 6 relativ zu dem Target bewegt wird, als auch dann, wenn das Substrat 6 während des Beschichtungsvorganges unter dem Target 3 ruht.

Eine optimale Ausrichtung der leichten Magnetisierungsachse wird besonders bei Verwendung einer Langkathode erreicht, da dann die magnetischen Streufelder der Magnetanordnung 4 sich bereits mit dem Magnetfeld der externen Magnetfelderzeugungseinrichtung 5 decken. Im Falle einer rotationssymmetrischen Zerstäubungskathode bzw. Magnetanordnung 4 wäre das magnetische Streufeld nicht mit dem Magnetfeld der externen Magnetfelderzeugungseinrichtung 5 deckungsgleich, was zu einer gegebenenfalls verschlechterten Ausrichtung der leichten Magnetisierungsachse führt.

Die Ausrichtung der leichten Magnetisierungsachse ist schematisch in Figur 2 veranschaulicht. Die Ausrichtung der leichten Magnetisierungsachse wie in Figur 2 gezeigt, d.h. einheitlich in eine Richtung, ist besonders dann notwendig, wenn das zu beschichtende Substrat als Magnetspeicher, insbesondere als MRAM-Speicher-Material verwendet werden soll.

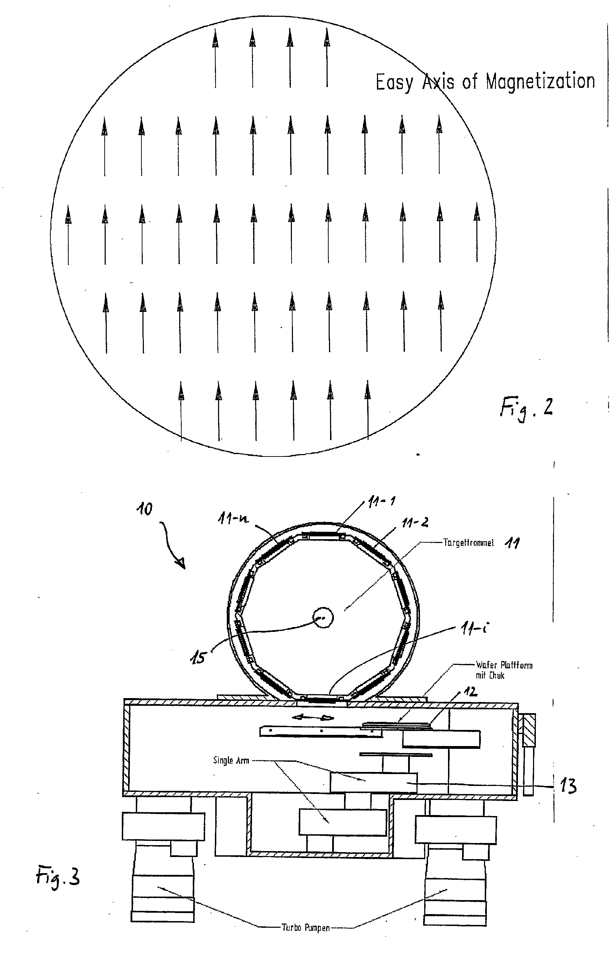

Figur 3 zeigt schematisch eine Schnittansicht der erfindungsgemäßen Vorrichtung 10 zum Beschichten eines Substrates 6 mit mehreren Schichten durch Kathodenzerstäubung. Im oberen Bereich des Bildes ist die Zerstäubungskathodenanordnung 11 mit den mehreren Zerstäubungskathoden 11-1, 11-2, ..., 11-n dargestellt. Die Zerstäubungskathoden befinden sich mit den radial nach außen weisenden Targetnutzflächen auf einer Kreisbahn, um dessen Mittelpunkt die Zerstäubungskathodenordnung 11 relativ zu dem Substrat drehbar ist. Das Substrat ist auf einem Substrathalter 12 in Pfeilrichtung relativ zu der Zerstäubungskathodenanordnung, d.h. der Targettrommel horizontal bewegbar. Dabei ist die gerade für die Beschichtung zu verwendende Bestäubungskathode 11-i in der Targettrommel an unterster Stelle, d.h. oberhalb der Beschichtungsposition des Substrates angeordnet. Mittels einer einmaligen oder mehrmaligen Horizontalbewegung des Substrates unterhalb des Targets werden je nach gewünschter Schichtdicke eine oder mehrere Schichten des vom Target zu zerstäubenden Materials auf das Substrat aufgebracht. Wenn die Zerstäubung mit dem Target 11-i abgeschlossen ist, wird die Targettrommel um ihre Achse gedreht, bis die Zerstäubungskathode mit dem nächsten gewünschten Target sich in der Zerstäubungsposition, d.h. an unterster Stelle der Targettrommel befindet. Dann erfolgt erneut ein einmaliges oder mehrmaliges Bewegen des Substrates unterhalb des Targets zum Beschichten einer Schicht.

Zum Bewegen des Substrates dient dabei ein mehrteiliger Roboterarm 13, der eine extrem genaue lineare Bewegung des Substrates relativ zu der Targettrommel ermöglicht.

Je nach Anwendungsbereich weist die Targettrommel mehrere Zerstäubungskathoden auf. Bevorzugt sind acht oder zehn Zerstäubungskathoden.

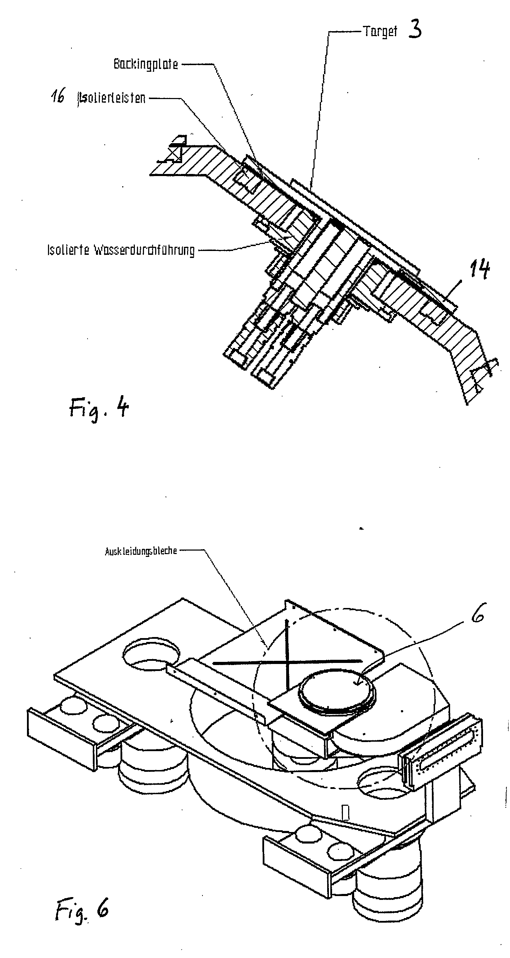

Figur 4 veranschaulicht die erfindungsgemäße Trennung von Target 3 und Magnetanordnung. Die Trommelwand der Targettrommel weist lediglich eine kleine Durchführung für die Wasser- und Stromzufuhr auf. Das Target 3 ist auf einer Grundplatte, beispielsweise einer Kupferplatte 14 im Inneren des Prozeßraumes vorgesehen. Die Magnetanordnung (in Figur 4 nicht gezeigt) ist erfindungsgemäß vom Prozeßraum getrennt außerhalb der Trommelwand (d.h. radial innerhalb der ringförmigen Trommel) angeordnet. Vorzugsweise ist dabei der Abstand zwischen Target und Magnetanordnung so gering wie möglich.

Figur 4 zeigt auch die Isolierleisten 16 zum Isolieren der Kathode gegen die Trommelwand.

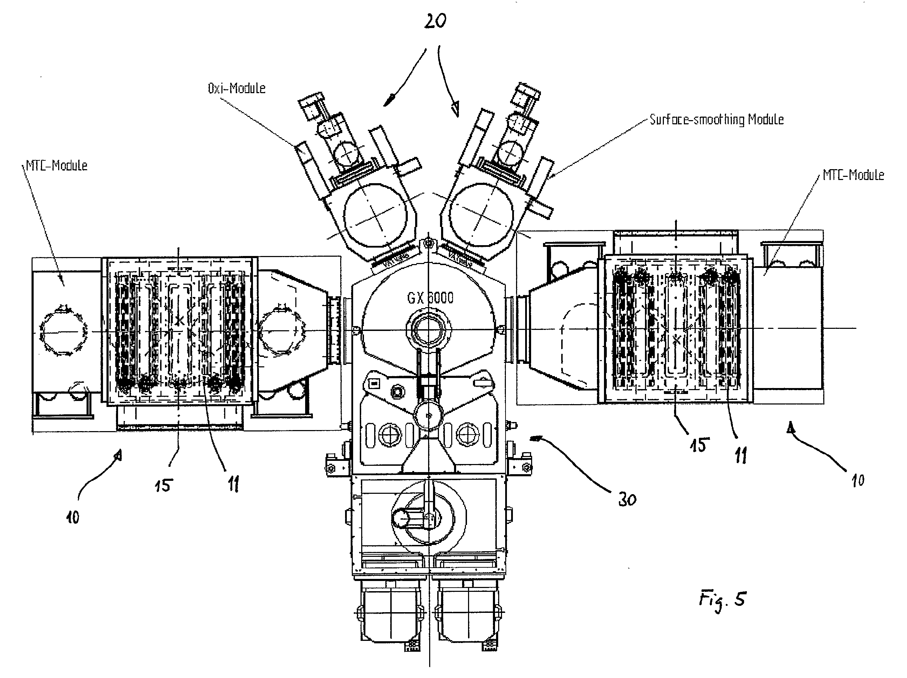

Figur 5 zeigt eine schematische Draufsicht einer kompletten Beschichtungsanlage mit zwei erfindungsgemäßen Beschichtungsvorrichtungen 10, die an einem Beschickungsmodul 30 angekoppelt sind. Die zu beschichtenden Substrate werden von dem Beschickungsmodul 30 in die Beschichtungsvorrichtungen 10 eingeführt, um dann anschließend in den Beschichtungsvorrichtungen mit den einzelnen Beschichtungen versehen zu werden. Wie in Figur 5 gezeigt, sind die Achsen 15 der Targettrommeln 11 senkrecht zur Bewegungsrichtung der Substrate von dem Beschickungsmodul 30 in die Beschichtungsvorrichtung 10 angeordnet. Wie bereits erläutert wird in der Beschichtungsvorrichtung das Substrat unterhalb des an unterster Stelle angeordneten Targets entlang bewegt. Anschließend wird die Targettrommel 11 je nach gewünschten Schichtaufbau auf dem Substrat so bewegt, daß die gewünschten Targets oberhalb der Bewegungsbahn des Substrates zur Beschichtung desselben angeordnet sind.

Figur 5 zeigt ferner zwei zusätzliche Module 20, mit denen beschichtete Oberflächen des Substrates weiteren Behandlungen unterzogen werden können.

Beispielsweise kann hier eine Oberfläche gezielt oxidiert oder gegebenenfalls geglättet werden.

Figur 6 zeigt ausschnittsweise einen Bestandteil der erfindungsgemäßen Beschichtungsvorrichtung, nämlich die Bewegungseinrichtung zum Bewegen des Substrates unterhalb der Targettrommel. Auch hier in Figur 6 ist der mehrteilige Roboterarm zu erkennen, der eine exakte lineare Bewegung des Substrates 6 relativ zum Target ermöglicht.

## Patentansprüche

1. Zerstäubungskathode für die Beschichtung eines Substrates (6), insbesondere mit magnetischen Werkstoffen, mit:
einem Kathodengrundkörper (2);
einem darauf angeordneten Target (3);
einer hinter dem Target (3) angeordneten Magnetanordnung (4); und
einer Einrichtung (5) zum Erzeugung eines externen Magnetfeldes mit im wesentlichen parallel verlaufenden Magnetfeldlinien (8) im wesentlichen in der Ebene des Substrats (6).

2. Kathode nach Anspruch 1, wobei die Kathode (1) eine Langkathode ist.

3. Kathode nach Anspruch 1 oder 2, wobei das externe Magnetfeld die leichte Magnetisierungsachse eines auf das Substrat (6) aufgebrachten Werkstoffes ausrichtet.

4. Kathode nach Anspruch 2 oder 3, wobei sich die externe Magnetfelderzeugungseinrichtung (5) entlang der Ausbreitungsrichtung des Targets (3) erstreckt.

5. Kathode nach einem der Ansprüche 1 bis 4, ferner mit einer Abschirmung (7) zum Abschirmen des nicht zu beschichtenden Bereiches der Kathode (1) zwischen Target (3) und Substrat (6).

6. Kathode nach einem der Ansprüche 1 bis 5, mit einer Einrichtung zur insbesondere translatorischen Relativbewegung des Substrates (6) bezüglich der Kathode (1) während der Kathodenzerstäubung.

7. Zerstäubungskathode, insbesondere nach einem der Ansprüche 1 bis 6, wobei der Kathodengrundkörper (2) mit dem darauf angeordneten Target (3) in einem Prozeßraum und die Magnetanordnung (4) von diesem durch eine Wand getrennt in der Umgebungsatmosphäre angeordnet sind.

8. Zerstäubungskathode nach einem der Ansprüche 1 bis 7, wobei die Stärke des externen Magnetfeldes einstellbar ist.

9. Vorrichtung (10) zum Beschichten eines Substrates (6) mit mehreren Schichten durch Kathodenzerstäubung, insbesondere mit magnetischen Werkstoffen, mit:
einer Anordnung (11) mehrerer Zerstäubungskathoden (11-1, 11-2, ..., 11-n) mit je einem Kathodengrundkörper (2), einem darauf angeordneten Target (3) und einer hinter dem Target (3) angeordneten Magnetanordnung (4);
wobei die mehreren Zerstäubungskathoden mit der Targetnutzfläche radial nach außen weisend auf einem Kreis angeordnet sind, um dessen Mittelpunkt (15) die Zerstäubungskathodenanordnung (11) relativ zu dem Substrat (6) drehbar ist, das im wesentlichen in einer Tangentialebene eines die Zerstäubungskathodenanordnung (11) umschreibenden Kreises angeordnet ist.

10. Vorrichtung nach Anspruch 9 mit einer Einrichtung (5) zum Erzeugen eines externen Magnetfeldes mit im wesentlichen parallel und im wesentlichen in der Ebene des Substrats (6) verlaufenden Magnetfeldlinien (8)

11. Vorrichtung nach Anspruch 9 oder 10, wobei die Zerstäubungskathoden Langkathoden sind.

12. Vorrichtung nach Anspruch 9, 10 oder 11, wobei das externe Magnetfeld die leichte Magnetisierungsachse eines auf das Substrat (6) aufgebrachten Werkstoffes ausrichtet.

13. Vorrichtung nach Anspruch 11 oder 12, wobei sich die Magnetfelderzeugungseinrichtung (5) entlang der Ausbreitungsrichtung der Targets (3) erstreckt.

14. Vorrichtung nach einem der Ansprüche 9 bis 13, ferner mit einer Einrichtung zur insbesondere translatorischen Relativbewegung des Substrates (6) bezüglich der Zerstäubungskathodenanordnung (11) während der Kathodenzerstäubung.

15. Vorrichtung nach einem der Ansprüche 9 bis 14, wobei die Kathodengrundkörper (2) mit den darauf angeordneten Targets (3) in einem Prozeßraum und die Magnetanordnungen (4) von diesem durch eine Wand getrennt in der Umgebungsatmosphäre angeordnet sind.

16. Vorrichtung nach einem der Ansprüche 9 bis 15, wobei für die Zerstäubungskathodenanordnung nur eine oder zwei Magnetanordnungen (4) vorgesehen sind, wobei die Kathodengrundkörper (2) mit den darauf angeordneten Targets (3) relativ zu den Magnetanordnungen (4) bewegbar sind.

17. Verfahren zum Beschichten eines Substrats (6) durch Kathodenzerstäubung, insbesondere mit einer Zerstäubungskathode nach einem der Ansprüche 1 bis 8,
wobei während der Zerstäubung ein externes Magnetfeld mit im wesentlichen parallel und in der Ebene des Substrats (6) verlaufenden Magnetfeldlinien vorgesehen ist.

18. Verfahren zum Beschichten eines Substrates mit mehreren Schichten, insbesondere mit magnetischen Werkstoffen, insbesondere mit der Vorrichtung nach einem der Ansprüche 9 bis 16, mit den Schritten:
(a) Aufbringen einer Schicht auf das Substrat (6) mittels einer Zerstäubungskathode;
(b) Ersetzen der Zerstäubungskathode durch eine andere Zerstäubungskathode;
(c) optionales translatorisches Bewegen eines Substrates relativ zu einer Zerstäubungskathode (1) im wesentlichen in der Ebene des Substrats (6) während des Schrittes (a); und
(d) Wiederholen der Schritte (a) bis (c).
